# EUROPEAN PATENT SPECIFICATION

(11) **EP 1 811 649 B1**
(45) Date of publication and mention of the grant of the patent: **18.09.2013**
(21) Application number: 07008103.9
(22) Date of filing: 16.04.1999
(51) Int. Cl.: H03D 7/14

(54) **Method for attenuating spurious signals and receiver**
Verfahren zum Abschwächen von Störsignalen sowie Empfangsgerät
Procédé pour l'atténuation de signaux parasites et récepteur

(30) Priority: 17.04.1998 FI 980858
(43) Date of publication of application: 25.07.2007
(62) Divisional of application: 99660061.5
(73) Proprietor: Nokia Corporation, 02150 Espoo (FI)
(72) Inventor: Murtojärvi, Simo, 24260 Salo (FI); Rauhala, Antti, 25130 Muurla (FI); Kimppa, Harri, 24280 Salo (FI)
(74) Representative: von Samson-Himmelstjerna, Friedrich

(56) References cited:
- WO-A-97/07596
- US-A- 5 379 457
- US-A- 5 392 003
- US-A- 5 584 066
- US-A- 5 613 233

## Description

The invention relates to a method for attenuating spurious signals in a transmitter and/or receiver in which radio signals are mixed to a second frequency, e.g. to an intermediate frequency (IF) or, in the case of so-called direct conversion, straight to the baseband, i.e. 0-Hz IF, and in addition the invention relates to a receiver.

When aiming at good linearity in radio reception, the biggest problem is usually the mixing of the received signal. Mixing is used for converting a high-frequency received signal down to a lower intermediate frequency. Attempts are made to attenuate in different ways the mixing results of even and odd orders which are brought about in the mixing in addition to the desired result. The mixing results of even orders are canceled by means of balanced or double-balanced mixer constructions. In the ideal situation, the even mixing results of two branches of a mixer cancel each other as being opposite. In practice, the attenuation caused by canceling is sufficient when the intermediate frequency is right and frequency-selective filtering is used. Then the frequencies causing the second order are attenuated already before the mixer down to a level where not too many of those frequencies will be generated in the mixer. However, there are receivers in which it is advantageous to use an intermediate frequency that might temporarily have a second-order spurious signal. Such a receiver is found e.g. in a multiple-frequency transceiver using one intermediate frequency and a common local oscillator.

Spurious responses will also be generated in a direct-conversion receiver, the worst being modulation-frequency interference at the receiver's mixer output caused by a strong amplitude-modulated (AM) signal of another transceiver. This will appear even if the frequency of the interfering signal considerably deviated from the receiving frequency. These interferences are mainly caused by the second-order distortion component which contains a variable-level DC component proportional to the amplitude of the interference-causing signal. The variable-amplitude signal produces at the mixer output a signal which comprises a variable DC component and the frequency of which is identical with the varying of the amplitude. This signal is attenuated in accordance with the mixer's balance accuracy and linearity. Sufficient attenuation can be achieved e.g. by using a mixer that has a good signal amplitude tolerance. In this way even spurious signals of a large amplitude will not cause a considerable interfering signal at the mixer output.

From the prior art it is known a so-called Gilbert cell which is widely used in integrated multiplier circuits of communications systems, especially in mobile communication devices. Multiplier circuits are used in integrated IF parts such as mixers and variable gain amplifiers.

A mixer can be based on a Gilbert cell. Such a mixer has to use large currents, high operating voltages and high local oscillator level to achieve a small relative portion of interfering signal and small effect on the mixer operating points. Additionally, the balance of the incoming RF signal, balance of the amplification of the different branches of the mixer, and the balance of the local oscillator are of great importance to the attenuation of spurious signals of even orders. The low voltage used nowadays because of the tendency to reduce power consumption causes that not all mixer types provide sufficient attenuation of spurious signals. Tolerances of the components used in the mixers are too wide to achieve a balance good enough at low voltages.

It is a problem with known radio receivers that single unbalanced mixers produce, in addition to the desired mixing result, spurious signals of both even and odd orders.

It is another problem with known radio receivers that spurious signals of even orders, which are generated in balanced mixers in addition to the desired mixing result, are insufficiently attenuated at low voltages.

WO 97/07596 A discloses a radio frequency mixer utilizing frequency and bias compensation for improved performance characteristics. The radio frequency mixer receives bias signals that are dependent on the power supply voltage levels to internally balance the local oscillation received and mix the perfectly bias balanced internally generated oscillation signal with the radio frequency input.

US-A-5 584 066 discloses balancing a mixer of a double superheterodyne receiver by adjusting bias voltages of transistors in the mixer in order to reduce carrier leakage through the mixer.

US-A-5 613 233 discloses an apparatus having a distortion cancelling feedback signal that suppresses undesired signal components. A balanced mixer is coupled to a common-mode detector, a filter and having a resulting feedback signal that suppresses the common-mode component of the mixer output signal while allowing the differential component of the mixer output signal to pass on to additional processing.

### Summary of the Invention

It is an object of the invention to improve the attenuation of spurious signals in a mixer such that an adequate result can be achieved even with lower operating voltages and smaller currents.

According to a first aspect, the invention provides a method for attenuating spurious signals in a mixer, according to the subject-matter of independent claim 1. A further aspect is directed to a receiver according to the subject-matter of independent claim 18. A still further aspect of the invention is directed to a mobile station according to the subject-matter of claim 36. Further aspects and embodiments of the invention are set forth in the dependent claims, the following description and the drawings.

According to an embodiment, the invention pertains to a method for attenuating spurious signals in receiver in which radio signals are mixed to a second frequency which may also be the baseband frequency. In accordance with the embodiment, mixing is balanced by adjusting transistor bias voltages and/or currents in the mixer circuit.

According to an embodiment, the invention also pertains to a receiver that comprises a mixer for mixing radio signals to a second frequency, which may also be the baseband frequency, and means for attenuating spurious signals while receiving radio signals. In accordance with the embodiment, it comprises balance-adjusting means of mixer circuit to adjust the balance of the circuit by adjusting transistor bias voltages and/or currents in the mixer circuit.

It is an advantage of the embodiments that in the mixing to a second frequency spurious signals of even orders caused by balance errors resulting from component tolerances are considerably attenuated.

The invention will now be described in more detail with reference to the accompanying drawing wherein
- Fig. 1: shows in the form of circuit diagram a known Gilbert cell,
- Fig. 2: shows in the form of flow diagram a method according to the invention for adjusting the balance of a mixer,
- Fig. 3: shows in the form of circuit diagram a bias voltage adjustment block of a mixer according to the invention,
- Fig. 4: shows in the form of circuit diagram a mixer according to the invention,
- Fig. 5: shows in the form of circuit diagram a radio-frequency stage according to the invention,
- Fig. 6: shows in the form of block diagram essential parts of a transceiver according to the invention, and
- Fig. 7: shows in the form of block diagram a controller according to the invention for controlling an adjustment block.

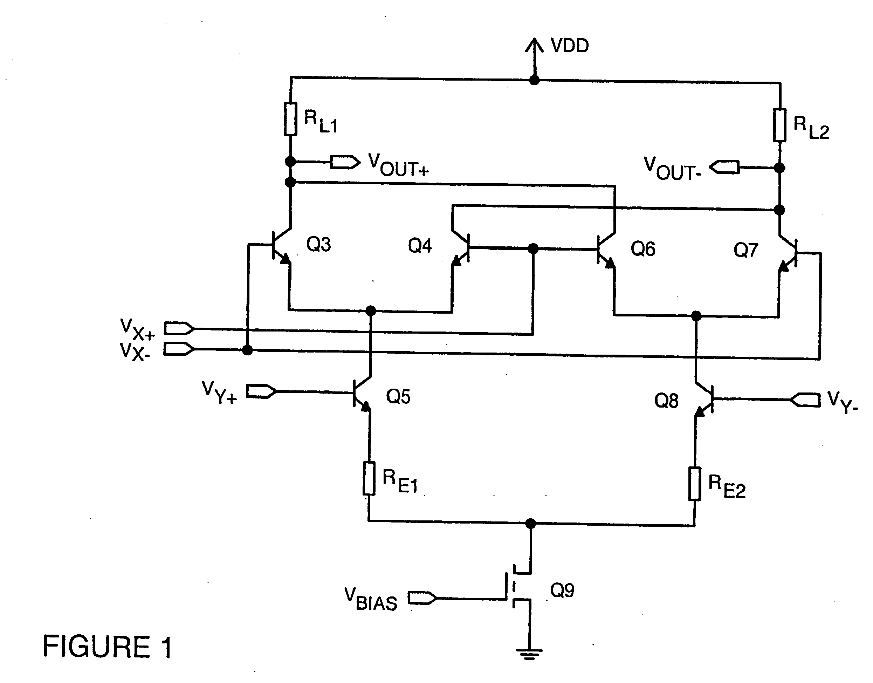

Fig. 1 shows a known Gilbert cell used for realizing integrated IF parts such as variable gain amplifiers and mixers. In a Gilbert cell two input voltages are multiplied into one output voltage, i.e. the voltage difference at the outputs is the product of the differences in the input voltages. A first voltage difference is coupled to terminals V_{X+} and V_{X-} wherefrom the voltages are taken to the bases of transistors Q3, Q4 and Q6, Q7, respectively. A second voltage difference is coupled to terminals V_{Y+} and V_{Y-} wherefrom the voltage is amplified by transistors Q5 and Q8. Transistors Q5 and Q8 are coupled through resistors R_{E1} and R_{E2} to a field effect transistor (FET) Q9 which is controlled by a bias voltage V_{BIAS} and coupled to a negative operating voltage. Transistors Q3 and Q7 amplify a positive voltage difference V_{X+} and V_{X-}, and the amplified voltage difference is coupled to outputs V_{OUT+} and V_{OUT-}. The circuit mentioned above is coupled to a positive operating voltage through resistors R_{L1} and R_{L2}. Transistors Q2 and Q4 amplify a negative voltage difference V_{X+} and V_{X-}, and the amplified voltage difference is crosscoupled to outputs V_{OUT+} and V_{OUT-}.

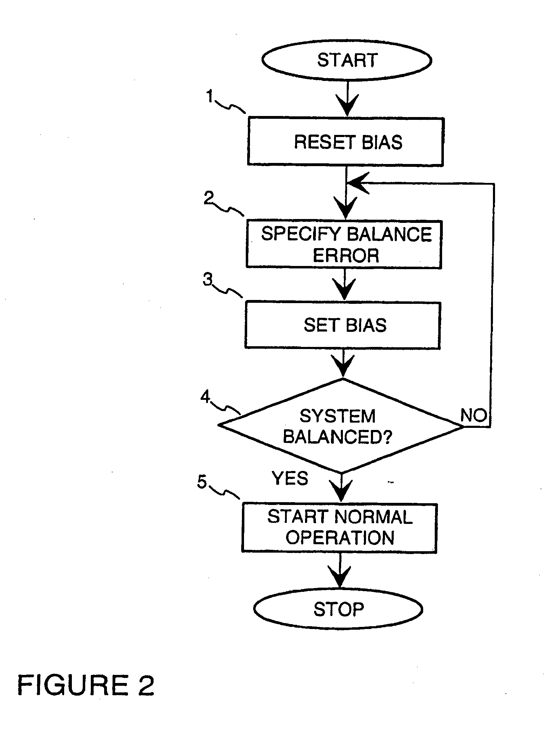

Fig. 2 shows in the form of flow diagram a balance adjustment method for a mixer according to the invention. First, possible previous bias voltages 1 are removed. Then, the balance error 2 of the mixer is determined by coupling a radio signal to the receiver inputs, thus causing a spurious signal in the mixer, which is then measured at the mixer outputs. Next, a bias voltage 3 correcting the balance error is set, preferably by feeding an inversely proportional CTRL byte corresponding to the error to the adjustment block by means of a digital controller. If the error-correcting bias voltage cannot be determined on the basis of the measurement result, a trial bias voltage is set. CTRL byte means a binary number that sets the control for the CTRL lines. The binary lines of the CTRL byte control the switching transistors in the adjustment block, so that I_{BIAS} is changed and the voltages between the terminals of the bias resistors change. The potential of the operating point of the mixer's transistor input is adjusted according to the point between the bias resistors. In other words, the adjustment block forms a variable voltage across the resistor in the series connection when the adjustment is carried out by means of current. The adjustment block may also be implemented using a variable voltage source. The operational input signals of the transistors are alternating voltages conducted by a capacitive component. When the bias voltage that corrects or at least changes the balance error has been generated, it is checked whether the error correction was successful, i.e. whether the mixer is in balance 4. If not, operation returns to step 2 to determine the remaining error and change the bias voltages on the basis of that determination. If the setting of the bias reduced the balance error, the bias is increased, but if the balance error became bigger the bias is taken back towards zero or, if zero is reached, the bias is set on the second line of the input pair. Thus, bias voltage remains advantageously only on one of the lines of the input pair in the balanced state. When the balancing has succeeded, the data of the balancing controller are stored in memory and normal operation of the mixer is started 5.

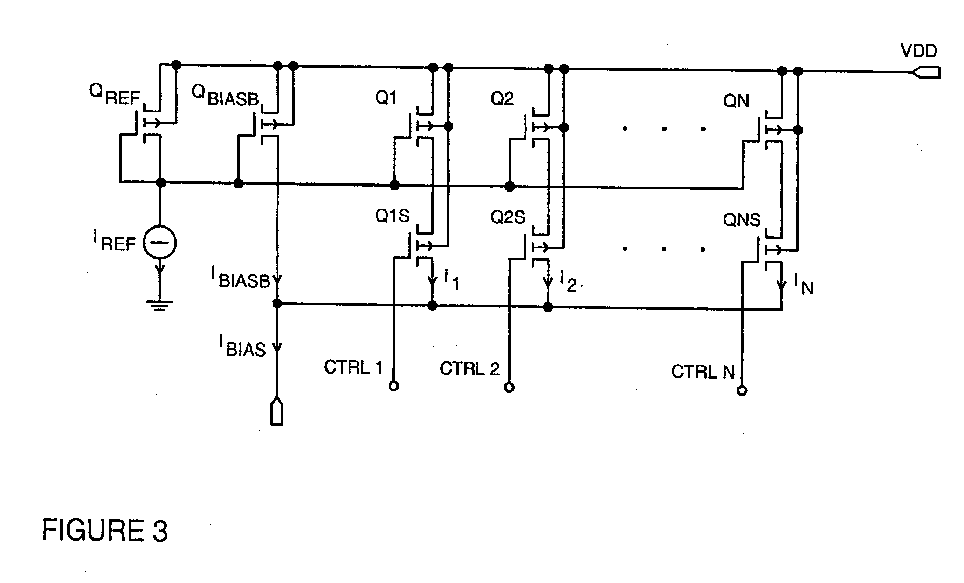

Fig. 3 shows in a circuit diagram an adjustment block for the bias voltage of a mixer according to the invention. In the adjustment block, a current from a reference current source I_{REF} flows via a transistor Q_{REF} from the operating voltage VDD to ground. Current I_{REF} is mirrored to a bias current circuit on the right. Current I_{BIASB} through transistor Q_{BIASB} constitutes the invariable fundamental part of bias current I_{BIAS}. Transistors Q1, Q2, ... QN and Q1S, Q2S, ... QNS make up N parallel series connections, and a sum current of I₁, I₂, ... IN through said series connections constitutes the variable part of bias current I_{BIAS}. Control lines CTRL 1, 2, ... N control transistors Q1S, Q2S, ... QNS serving as switches. Transistors Q1, Q2, ... QN are mutually binarily weighted such that transistors Q1S, Q2S, ... QNS, which are controlled by control lines CTRL 1, 2, ... N and connected in series with said transistors, can raise current I_{BIAS} by 2^{N}-1 levels, which means the current gets 2^{N} values. Binary weighting of the currents is achieved e.g. by connecting transistors in parallel in such a way that Q1 comprises one transistor, Q2 comprises two transistors, etc. With field effect transistors (FET), the currents may also be set by selecting the channel widths. The currents are weighted preferably according to the following series: 1, 2, 4, 8, etc., i.e. 2^{N}, where N ≥ 0. For example, current I₁ is I_{REF}/200, current I₂ is I_{REF}/100 and IN is I_{REF}/(200/2^{N-1}).

Thus the imbalance caused by the tolerances of mixer components can be balanced using the variable part I₁, I₂, ... IN of current I_{BIAS}. Also, possible small imbalance of input signals can be balanced using the arrangement according to the invention. By changing the number of control lines and the current I_{REF} of the reference current source it is possible to adapt the bias adjustment steps and range to various couplings.

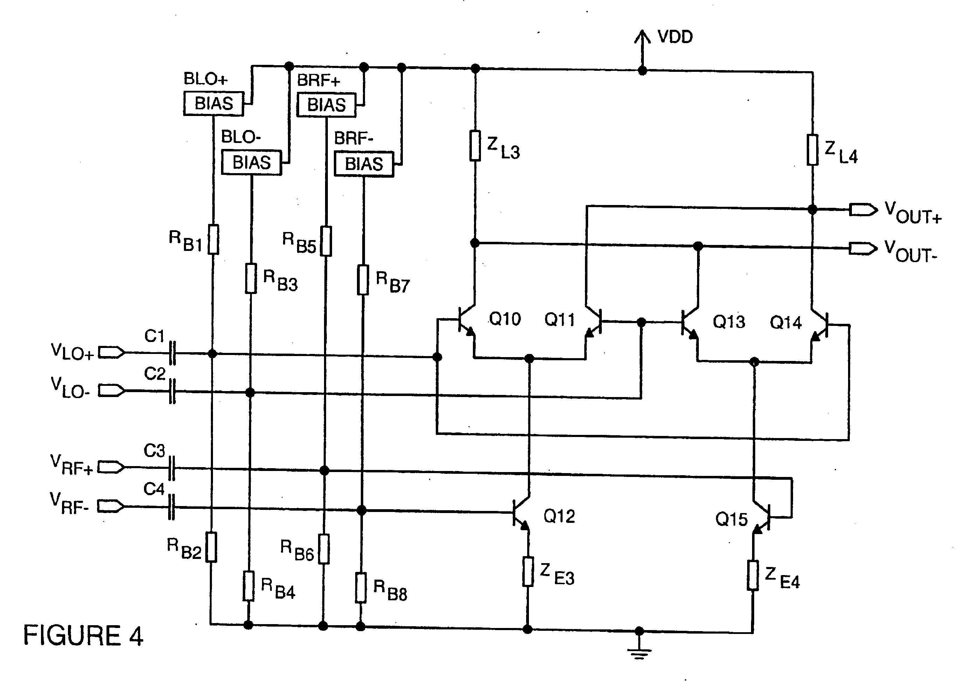

Fig. 4 shows in a circuit diagram a mixer according to the invention. In the upper left corner of Fig. 4 there are four blocks depicted in Fig. 3 that generate the bias current I_{BIAS} to control the bias voltage. The blocks are for local oscillator signal pair V_{LO+} and V_{LO-} and radio-frequency signal pair V_{RF+} and V_{RF-}, which control through capacitive elements C1 and C2 as well as C3 and C4 the transistors Q10, Q11, Q13, Q14 and Q12, Q15. Blocks BLO+, BLO-, BRF+ and BRF- are used to produce currents and, thus, voltages to four parallel bias resistor series connections R_{B1} and R_{B2}, R_{B3} and R_{B4}, R_{B5} and R_{B6} as well as R_{B7} and R_{B8}.

If the adjustment block current I_{BIAS} is the same as the necessary base current of the corresponding transistor, e.g. a beta-compensated base current, a resistor connected to ground is not used with that adjustment block. For example, if adjustment blocks BRF+ and BRF- feed the base current of transistors Q15 and Q12, resistors R_{B6} and R_{B8} are left out and the corresponding bias voltage is set by adjusting the base current.

Load impedances Z_{L3}, Z_{L4}, transistors Q10, Q11, Q12, Q13, Q14, Q15 and emitter impedances Z_{E3}, Z_{E4} constitute a known mixer the outputs of which give signals V_{OUT+} and V_{OUT-}.

The balance is adjusted preferably as described above, but the most perfect balance is achieved by adjusting the bias voltages of the transistor pair's mutually corresponding transistors Q10, Q11 and Q13, Q14 separately. In other words, the controls of the transistors that get their control from the same line, such as Q10 and Q14, are separated from each other and the bias voltages of them both are adjusted individually.

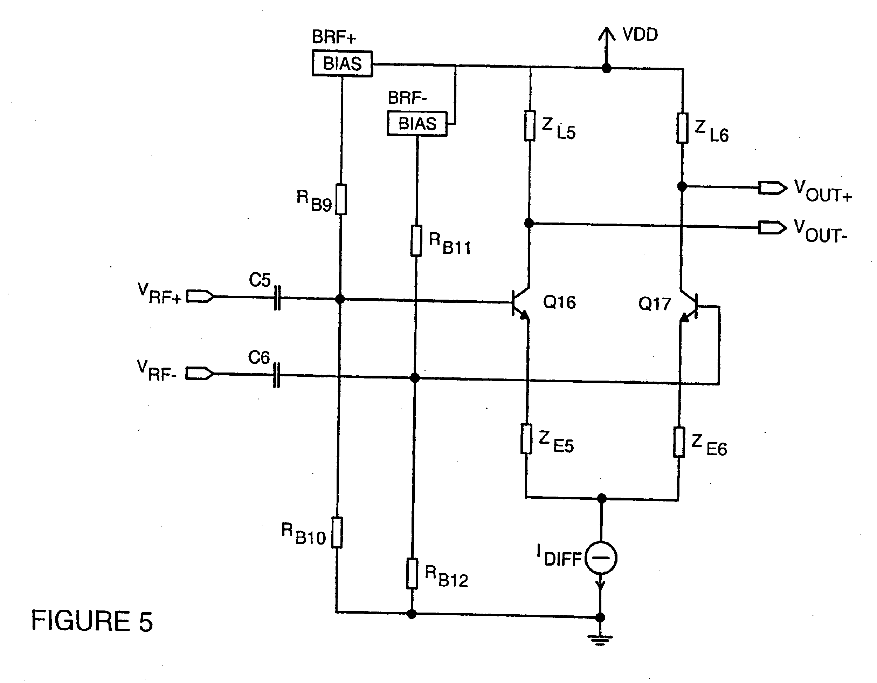

Fig. 5 shows in a circuit diagram a radio-frequency amplifier stage according to the invention which also can be used to correct a mixer's balance error. In the upper left corner of Fig. 5 there are two blocks depicted in Fig. 3 that generate the bias current I_{BIAS} to control the bias voltage. The blocks are for a radio-frequency signal pair V_{RF+} and V_{RF-} which control through capacitive elements C5 and C6 transistors Q16 and Q17. Blocks BRF+ and BRF- are used to produce currents and, thus, voltages to two parallel bias resistor series connections R_{B9}, R_{B10} and R_{B11}, R_{B12}.

Load impedances Z_{L5}, Z_{L6}, transistors Q16, Q17, emitter impedances Z_{E5}, Z_{E6} and current source I_{DIFF} constitute a known radio-frequency amplifier stage.

The circuit according to Fig. 5 described above can also be used as local oscillator buffer. Then the balance error of the local oscillator port can be corrected by adjusting the buffer.

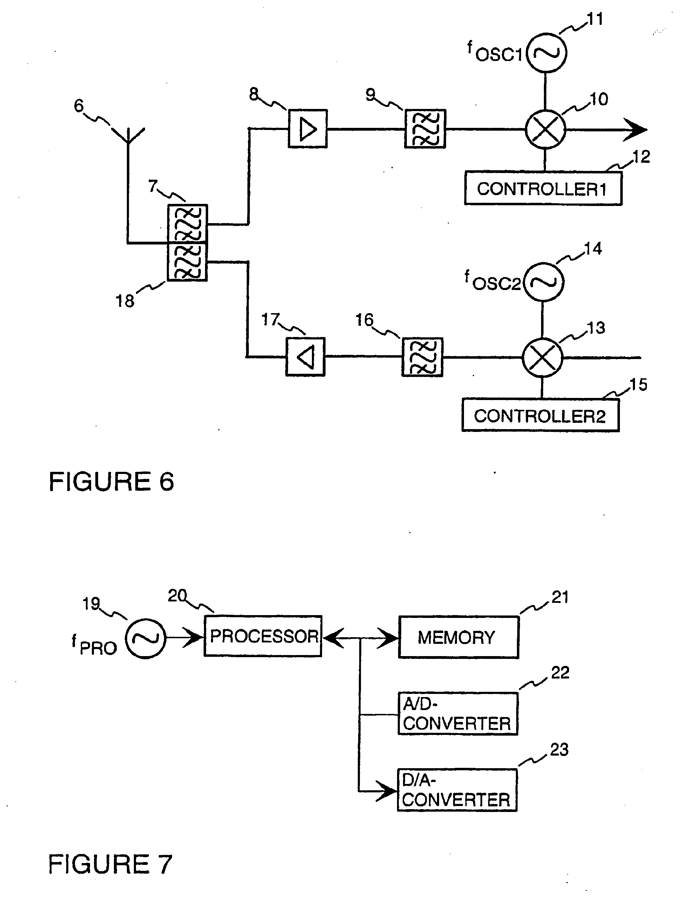

Fig. 6 shows in the form of block diagram essential parts of a transceiver according to the invention. The transceiver shares a common antenna 6 from which a signal is received and filtered by a bandpass filter 7 and amplified by an amplifier 8 and refiltered 9. Then the signal at the radio reception frequency is mixed to an intermediate frequency in a balanced mixer 10 according to the invention. A local oscillator 11 feeds the mixer 10 at the frequency of f_{OSC1}. The balance of the mixer 10 is adjusted by a controller 12. From the intermediate frequency on the reception continues in accordance with the prior art.

A signal to be transmitted is modulated at the local oscillator 14 frequency f_{OSC2} by means of a modulator 13. The balance of the modulator 13 is adjusted by a controller 15. The modulated signal is bandpass-filtered by a filter 16 and amplified by an amplifier 17 and filtered again by a filter 18 and fed to the antenna 6. Otherwise the transmitter is preferably realized according to the prior art, and this document does not take a position on the use of balancing according to the invention in it.

Fig. 7 shows in a block diagram essential components of a controller of an adjustment block according to the invention. The processor 20 of a digital controller is stepped by an oscillator 19 at frequency f_{PRO}. The controller executes a program from memory 21, which preferably is both read only memory (ROM) and random access memory (RAM). Measurement data on the balance is obtained by means of an A/D converter 22. Bias voltages are controlled by a D/A converter 23 which preferably comprises an adjustment block according to Fig. 3 in which current is switched by means of digital binary control to adjust the bias voltages.

For example, let us consider a radio receiver the spurious response of which is to be reduced. The receiver is adjusted preferably only once before use. A test signal is coupled to the receiver input, and the interfering signal level is measured from the receiver output. The test signal is generated in such a way that it produces a spurious response to be minimized. A trial setting is chosen e.g. for the adjustment block BRF+ of the positive line of the RF input, and the interfering signal level is measured again. If the interference was reduced, an optimum setting is found for the adjustment block BRF+ by experimental bracketing, and if the interference got worse, the initial state is restored for the adjustment block BRF+ and a trial setting is chosen for the adjustment block BRF- of the negative line of the RF input and an optimum setting is found for it by experimental bracketing. The same experimental bracketing is also carried out for the local oscillator input by adjustment blocks BLO+ and BLO-. For a good result, both bracketing tunings are repeated. Thanks to the second tuning, a possible residual error, which is not noticed at the first time because it is hidden by an error in one of the input pairs, is corrected. Tuning data for the balance achieved through the minimization of spurious response are stored in the memory of the apparatus wherefrom they can be loaded by means of a microprocessor or digital signal processor (DSP) always on start-up. Fuses, microswitches, programmable gate circuits and the like can also be used for the immediate control of the adjustment block.

Of course, the selection of the bias voltage initial setting line and the level of the setting can also be realized as a preferably calculatory value based on interference measurement data. Empirical knowledge can also be utilized when estimating the bias voltage value on the basis of the measurement result.

In digital mobile communications devices, such as mobile stations operating in GSM, PCN (Personal Communication Network), DAMPS (Digital Advanced Mobile Phone Standard) or CDMA (Code Division Multiple Access) networks, the received signal is converted digital. In these apparatus the method is advantageously applied in such a way that the spurious response is measured, adjusted as small as possible, and the settings are stored in memory by carrying out the necessary routines with a digital signal processor. Then the tuning is particularly fast as it is carried out by coupling a test signal to the antenna and executing a tuning program. The adjustment blocks are controlled by a microprocessor or preferably with the same digital signal processor. A serial or parallel bus is used for the control. For a serial bus an adjustment block needs a separate logic to control the transistors.

The balance can also be tuned without a test signal while the local oscillator is operating. To that end, a comparative element is coupled to the mixer outputs to compare the voltage difference of the output pair. Particularly the DC component is compared. Tuning is performed by decreasing the voltage difference to its minimum value. However, because of bias voltages in the comparative element itself, the inputs of the comparative element must switch places and the comparison has to be repeated. The average of the tunings gives a result which is as accurate as possible. However, this tuning result is not as accurate as the one achieved using a test signal. If this type of tuning is accurate enough for the application, the tuning can be carried out automatically with a digital signal processor.

The principles according to the invention can also be utilized in the balancing of passive mixers.

The exemplary adjustment block was here realized by field effect transistors but the circuit can also be realized using bipolar transistors, for example.

The invention is not limited to the exemplary embodiments described above but many modifications are possible within the scope of the inventional idea defined by the claims set forth below.

## Claims

1. A method for attenuating spurious signals in a mixer (10) of a receiver wherein radio signals of a first frequency are mixed to a second frequency by mixing the radio signals with local oscillator signals, said method comprising:
measuring a mixer balance error at the output of the mixer (10),
adjusting bias voltages (3) or currents of transistors of the mixer (10) to reduce the mixer balance error and thus obtaining balance tuning data for the bias voltages (3) or currents for which the mixer (10) is in balance,
and, when the operation of the mixer (10) is started, generating the bias voltages (3) or currents based on the balance tuning data and setting the generated bias voltages (3) or currents of the transistors of the mixer (10).

2. The method of claim 1, wherein the adjustment of the bias voltages (3) or currents is digitally controlled.

3. The method of claim 1, wherein voltage measurement data from the mixer output indicating balance is converted to digital form (A/D) and the digital data is utilized to set adjusted bias voltages (3) or currents.

4. The method of one of the preceding claims, wherein step of obtaining the balance tuning data are controlled by a digital signal processor and/or microprocessor.

5. The method of one of the preceding claims, wherein a tuning program is executed to obtain the balance tuning data.

6. The method of one of the preceding claims, wherein the balance tuning data is stored in a memory and the setting is controlled by a digital signal processor.

7. The method of one of the preceding claims, wherein the adjusting of the bias voltages or currents is repeated until the mixer balance error is minimized.

8. The method of one of the preceding claims, wherein the adjusting further comprises coupling a test signal to a signal path via an input of the receiver and measuring the balance from the mixer output to determine the balance tuning data.

9. The method of one of the preceding claims, further comprising storing of the balance tuning data for the balance achieved in a memory and loading the balance tuning data by means of a microprocessor or digital signal processor (DSP) on start-up.

10. The method of one of the preceding claims, which is adapted to be carried out in a GSM communication system.

11. The method of one of the preceding claims, which is adapted to be carried out in a CDMA communication system.

12. The method of claim 10 or 11, wherein the method steps are carried out with a digital signal processor.

13. The method of claim 10 or 11, wherein the balance tuning data is obtained by coupling a test signal to an antenna of the receiver and executing a tuning program.

14. The method of one of the preceding claims, wherein the bias voltages (3) or currents are adjusted in an input circuit of a radio-frequency signal.

15. The method of one of the preceding claims, wherein the bias voltages (3) or currents are adjusted in an input circuit of a local oscillator.

16. The method of one of the preceding claims, wherein the bias voltages (3) or currents are adjusted separately for both transistors of a transistor pair of a signal line in the mixer.

17. The method of one of the preceding claims, wherein the adjustment of the bias voltages (3) or currents is performed using a digital-to-analog converter to adjust current for the signal line across parallel resistors.

18. A receiver, comprising:
a mixer (10) for mixing radio signals of a first frequency to a second frequency by mixing the radio signals with local oscillator signals, and
means for attenuating spurious signals when receiving the radio signals,
**characterized in that**:
said means for attenuating spurious signals comprises balance adjustment means (12) which is adapted to measure a mixer balance error at the output of the mixer (10), adjust the bias voltages (3) or currents of transistors (Q10, Q11, Q12, Q13, Q14, Q15) of the mixer (10) to reduce the mixer balance error and thus obtaining balance tuning data for the bias voltages (3) or currents, and, when the operation of the mixer (10) is started, generate the bias voltages (3) or currents based on the balance tuning data and set the generated bias voltages (3) or currents of the transistors (Q10, Q11, Q12, Q13, Q14, Q15) of the mixer (10).

19. The receiver of claim 18, wherein the balance adjustment means (12) is adapted to digitally control the adjustment of the bias voltages (3) or currents.

20. The receiver of claim 18, wherein the balance adjustement means (12) is adapted to convert voltage measurement data from the mixer output indicating balance to digital form (A/D) and to set the adjusted bias voltages (3) or currents based on the digital data.

21. The receiver of one of the claims 18 to 20, comprising a digital signals processor and/or microprocessor adapted to obtain the balance tuning data.

22. The receiver of one of the claims 18 to 21, comprising a tuning program by execution of which the balance tuning data is obtained.

23. The receiver of one of claims 18 to 22, wherein the balance tuning data is stored in a memory and the setting is controlled by a digital signal processor.

24. The receiver of one of the claims 18 to 23, wherein the balance adjustment means is adapted to repeat adjusting the bias voltages (3) or currents until the mixer balance error is minimized.

25. The receiver of one of the claims 18 to 24, further comprising a signal path for receiving a test signal, and said balance adjustment means (12) being adapted to measure the balance from the mixer output to determine the balance tuning data.

26. The receiver of one of the claims 18 to 25, further comprising a memory (21) for storing the balance tuning data for the balance achieved, and loading the balance tuning data by means of a microprocessor or digital signal processor (DSP) on start-up.

27. The receiver of one of the claims 18 to 26, which is adapted to operate in a GSM communication system.

28. The receiver of one of the claims 18 to 27, which is adapted to operate in a CDMA communication system.

29. The receiver of claim 27 or 28, comprising a digital signal processor adapted to carry out the tuning of the receiver.

30. The receiver of claim 27 or 28, further comprising means for coupling a test signal to an antenna of the receiver and means for executing a tuning program.

31. The receiver of one of the claims 18 to 30, wherein the adjustment means (12) comprises an input circuit (VRF+, VRF-, C3, C4) for a radio-frequency signal to adjust bias voltages or currents of an adjustment circuit (BRF+, BRF-, RB5, RB6, RB7, RB8) .

32. The receiver of one of the claims 18 to 31, wherein the adjustment means (12) comprises a local oscillator input circuit (VLO+, VLO-, C1, C2) to adjust bias voltages or currents of an adjustment circuit (BLO+, BLO-, RB1, RB2, RB3, RB4).

33. The receiver of one of the claims 18 to 32, wherein the balance adjustment means (12) comprises an adjustment circuit separately for both transistors of a transistor pair (Q10, Q14; Q11, Q13) of a signal line (VLO+, VLO-) of the mixer (10) to adjust bias voltages or currents.

34. The receiver of one of the claims 18 to 33, wherein the balance adjustment means comprises a digital-to-analog converter (19) to adjust bias voltages or currents with a digital controller (12).

35. The receiver of one of the claims 18 to 34, further comprising
an A/D converter (18) to measure the balance;
a D/A converter (19) to adjust bias voltages or currents; and
an oscillator (15), a processor (16) and memory (17) to carry out balance measurement routines as well as bias voltage or current adjustment routines.

36. A mobile station comprising a receiver according to any one of the claims 18 to 35.

37. Use of a mixer in a receiver according to any one of the claims 18 to 35.

## Patentansprüche

1. Verfahren zum Dämpfen von Störsignalen in einem Mischer (10) eines Empfängers, worin Funksignale einer ersten Frequenz mit einer zweiten Frequenz durch Mischen der Funksignale mit Empfangsoszillatorsignalen gemischt werden, wobei das Verfahren Folgendes umfasst:
Messen eines Mischerbalancefehlers an dem Ausgang des Mischers (10),
Anpassen der Vorspannungen (3) oder -ströme der Transistoren des Mischers (10), um den Mischerbalancefehler zu verringern und dadurch Balanceabstimmdaten für die Vorspannungen (3) oder -ströme zu erhalten, für die der Mischer (10) in Balance ist,
und dann, wenn der Betrieb des Mischers (10) begonnen hat, Erzeugen der Vorspannungen (3) oder -ströme anhand der Balanceabstimmdaten und Einstellen der erzeugten Vorspannungen (3) oder -ströme der Transistoren des Mischers (10).

2. Verfahren nach Anspruch 1, wobei das Anpassen der Vorspannungen (3) oder -ströme digital gesteuert wird.

3. Verfahren nach Anspruch 1, wobei Spannungsmessdaten von dem Mischerausgang, die die Balance anzeigen, in eine digitale Form (A/D) umgesetzt werden und die digitalen Daten verwendet werden, um die angepassten Vorspannungen (3) oder -ströme einzustellen.

4. Verfahren nach einem der vorhergehenden Ansprüche, wobei der Schritt des Erhaltens der Balanceabstimmdaten durch eine digitale Signalverarbeitungseinheit und/oder einen Mikroprozessor gesteuert wird.

5. Verfahren nach einem der vorhergehenden Ansprüche, wobei ein Abstimmprogramm ausgeführt wird, um die Balanceabstimmdaten zu erhalten.

6. Verfahren nach einem der vorhergehenden Ansprüche, wobei die Balanceabstimmdaten in einem Speicher gespeichert werden und das Einstellen durch eine digitale Signalverarbeitungseinheit gesteuert wird.

7. Verfahren nach einem der vorhergehenden Ansprüche, wobei das Anpassen der Vorspannungen oder -ströme wiederholt wird, bis der Mischerbalancefehler minimiert ist.

8. Verfahren nach einem der vorhergehenden Ansprüche, wobei das Anpassen ferner umfasst, ein Testsignal über einen Eingang des Empfängers in einen Signalweg einzukoppeln und die Balance des Mischerausgangs zu messen, um die Balanceabstimmdaten zu bestimmen.

9. Verfahren nach einem der vorhergehenden Ansprüche, das ferner umfasst, die Balanceabstimmdaten für die erreichte Balance in einem Speicher zu speichern und die Balanceabstimmdaten nach der Inbetriebnahme mittels eines Mikroprozessors oder einer digitalen Signalverarbeitungseinheit (DSP) zu laden.

10. Verfahren nach einem der vorhergehenden Ansprüche, das ausgelegt ist, in einem GSM-Kommunikationssystem ausgeführt zu werden.

11. Verfahren nach einem der vorhergehenden Ansprüche, das ausgelegt ist, in einem CDMA-Kommunikationssystem ausgeführt zu werden.

12. Verfahren nach Anspruch 10 oder 11, wobei die Verfahrensschritte mit einer digitalen Verarbeitungseinheit ausgeführt werden.

13. Verfahren nach Anspruch 10 oder 11, wobei die Balanceabstimmdaten durch Einkoppeln eines Testsignals in eine Antenne des Empfängers und Ausführen eines Abstimmprogramms erhalten werden.

14. Verfahren nach einem der vorhergehenden Ansprüche, wobei die Vorspannungen (3) oder -ströme in einer Eingangsschaltung eines Funkfrequenzsignals angepasst werden.

15. Verfahren nach einem der vorhergehenden Ansprüche, wobei die Vorspannungen (3) oder -ströme in einer Eingangsschaltung eines Empfangsoszillators angepasst werden.

16. Verfahren nach einem der vorhergehenden Ansprüche, wobei die Vorspannungen (3) oder -ströme für beide Transistoren eines Transistorpaars einer Signalleitung in dem Mischer einzeln angepasst werden.

17. Verfahren nach einem der vorhergehenden Ansprüche, wobei die Anpassung der Vorspannungen (3) oder -ströme unter Verwendung eines Digital-Analog-Umsetzers ausgeführt wird, um den Strom für die Signalleitung über parallele Widerstände anzupassen.

18. Empfänger, der Folgendes umfasst:
einen Mischer (10) zum Mischen von Funksignalen einer ersten Frequenz mit einer zweiten Frequenz durch Mischen der Funksignale mit Empfangsoszillatorsignalen und
Mittel zum Dämpfen von Störsignalen, wenn die Funksignale empfangen werden,
**dadurch gekennzeichnet, dass**
die Mittel zum Dämpfen von Störsignalen Balanceanpassungsmittel (12) umfassen, die ausgelegt sind, den Mischerbalancefehler an dem Ausgang des Mischers (10) zu messen, die Vorspannungen (3) oder -ströme der Transistoren (Q10, Q11, Q12, Q13, Q14, Q15) des Mischers (10) anzupassen, um den Mischerbalancefehler zu verringern, und dadurch Balanceabstimmdaten für die Vorspannungen (3) oder -ströme zu erhalten, und dann, wenn der Betrieb des Mischers (10) begonnen hat, die Vorspannungen (3) oder -ströme anhand der Balanceabstimmdaten zu erzeugen und die erzeugten Vorspannungen (3) oder -ströme der Transistoren (Q10, Q11, Q12, Q13, Q14, Q15) des Mischers (10) einzustellen.

19. Empfänger nach Anspruch 18, wobei das Balanceanpassungsmittel (12) ausgelegt ist, das Anpassen der Vorspannungen (3) oder -ströme digital zu steuern.

20. Empfänger nach Anspruch 18, wobei das Balanceanpassungsmittel (12) ausgelegt ist, Spannungsmessdaten von dem Mischerausgang, die die Balance angeben, in eine digitale Form umzusetzen (A/D) und die angepassten Vorspannungen (3) oder -ströme anhand der digitalen Daten einzustellen.

21. Empfänger nach einem der Ansprüche 18 bis 20, der eine digitale Signalverarbeitungseinheit und/oder einen Mikroprozessor umfasst, die ausgelegt sind, die Balanceabstimmdaten zu erhalten.

22. Empfänger nach einem der Ansprüche 18 bis 21, der ein Abstimmprogramm umfasst, durch dessen Ausführung die Balanceabstimmdaten erhalten werden.

23. Empfänger nach einem der Ansprüche 18 bis 22, wobei die Balanceabstimmdaten in einem Speicher gespeichert werden und das Einstellen durch eine digitale Signalverarbeitungseinheit gesteuert wird.

24. Empfänger nach einem der Ansprüche 18 bis 23, wobei die Balanceanpassungsmittel ausgelegt sind, das Anpassen der Vorspannungen (3) oder -ströme zu wiederholen, bis der Mischerbalancefehler minimiert ist.

25. Empfänger nach einem der Ansprüche 18 bis 24, der ferner einen Signalweg umfasst, um ein Testsignal zu empfangen, und wobei die Balanceanpassungsmittel (12) ausgelegt sind, die Balance von dem Mischerausgang zu messen, um die Balanceabstimmdaten zu bestimmen.

26. Empfänger nach einem der Ansprüche 18 bis 25, der ferner einen Speicher (21) umfasst, um die für die Balance erreichten Balanceabstimmdaten zu speichern und die Balanceabstimmdaten nach der Inbetriebnahme mittels eines Mikroprozessors oder einer digitalen Signalverarbeitungseinheit (DSP) zu laden.

27. Empfänger nach einem der Ansprüche 18 bis 26, der ausgelegt ist, in einem GSM-Kommunikationssystem zu arbeiten.

28. Empfänger nach einem der Ansprüche 18 bis 27, der ausgelegt ist, in einem CDMA-Kommunikationssystem zu arbeiten.

29. Empfänger nach Anspruch 27 oder 28, der eine digitale Signalverarbeitungseinheit umfasst, die ausgelegt ist, das Abstimmen des Empfängers auszuführen.

30. Empfänger nach Anspruch 27 oder 28, der ferner Mittel zum Einkoppeln eines Testsignals in eine Antenne des Empfängers und Mittel zum Ausführen eines Abstimmprogramms umfasst.

31. Empfänger nach einem der Ansprüche 18 bis 30, wobei die Anpassungsmittel (12) eine Eingangsschaltung (VRF+, VRF-, C3, C4) für ein Funksignal umfassen, um Vorspannungen oder -ströme einer Anpassungsschaltung (BRF+, BRF-, RB5, RB6, RB7, RB8) anzupassen.

32. Empfänger nach einem der Ansprüche 18 bis 31, wobei die Anpassungsmittel (12) eine Empfangsoszillatoreingangsschaltung (VLO+, VLO-, C1, C2) umfassen, um Vorspannungen oder -ströme einer Anpassungsschaltung (BLO+, BLO-, RB1, RB2, RB3, RB4) anzupassen.

33. Empfänger nach einem der Ansprüche 18 bis 32, wobei die Balanceanpassungsmittel (12) für beide Transistoren eines Transistorpaars (Q10, Q14; Q11, Q13) einer Signalleitung (VLO+, VLO-) des Mischers (10) jeweils eine Anpassungsschaltung umfassen, um Vorspannungen oder -ströme anzupassen.

34. Empfänger nach einem der Ansprüche 18 bis 33, wobei die Balanceanpassungsmittel einen Digital/Analog-Umsetzer (19) umfassen, um Vorspannungen oder -ströme mit einer digitalen Steuereinheit (12) anzupassen.

35. Empfänger nach einem der Ansprüche 18 bis 34, der ferner Folgendes umfasst
einen A/D-Umsetzer (18), um die Balance zu messen;
einen D/A-Umsetzer (19), um Vorspannungen oder -ströme anzupassen; und
einen Oszillator (15), eine Verarbeitungseinheit (16) und einen Speicher (17), um sowohl Balancemessprogramme als auch Vorspannungs- oder Vorstromanpassungsprogramme auszuführen.

36. Mobilstation, die einen Empfänger nach einem der Ansprüche 18 bis 35 umfasst.

37. Verwendung eines Mischers in einem Empfänger nach einem der Ansprüche 18 bis 35.

## Revendications

1. Procédé pour atténuer les signaux parasites dans un mélangeur (10) d'un récepteur dans lequel des signaux radio d'une première fréquence sont mélangés pour obtenir une deuxième fréquence en mélangeant les signaux radio à des signaux d'un oscillateur local, ledit procédé comprenant les étapes consistant à :
mesurer une erreur d'équilibre de mélangeur à la sortie du mélangeur (10),
régler les tensions (3) ou courants de polarisation de transistors du mélangeur (10) pour réduire l'erreur d'équilibre de mélangeur et obtenir ainsi des données d'accord d'équilibre pour les tensions (3) ou courants de polarisation pour lesquelles le mélangeur (10) est en équilibre, et
lors du démarrage du mélangeur (10), générer les tensions (3) ou courants de polarisation sur la base des données d'accord d'équilibre et fixer les tensions (3) ou courants de polarisation générés des transistors du mélangeur (10).

2. Procédé selon la revendication 1, dans lequel l'étape consistant à régler les tensions (3) ou courants de polarisation est commandée numériquement.

3. Procédé selon la revendication 1, dans lequel des données de mesure de tension issues de la sortie du mélangeur indiquant l'équilibre sont converties sous forme numérique (A/N) et les données numériques sont utilisées pour fixer les tensions (3) ou courants de polarisation réglés.

4. Procédé selon l'une des revendications précédentes, dans lequel l'étape consistant à obtenir les données d'accord d'équilibre est commandée par un processeur de signal numérique et/ou un microprocesseur.

5. Procédé selon l'une des revendications précédentes, dans lequel un programme d'accord est exécuté pour obtenir les données d'accord d'équilibre.

6. Procédé selon l'une des revendications précédentes, dans lequel les données d'accord d'équilibre sont enregistrées dans une mémoire et l'étape consistant à fixer les tensions (3) ou courants de polarisation est commandée par un processeur de signal numérique.

7. Procédé selon l'une des revendications précédentes, dans lequel l'étape consistant à régler les tensions ou courants de polarisation est répétée jusqu'à ce que l'erreur d'équilibre de mélangeur soit réduite à un minimum.

8. Procédé selon l'une des revendications précédentes, dans lequel l'étape consistant à régler les tensions ou courants de polarisation comprend en outre l'étape consistant à coupler un signal-test à un trajet de signal par une entrée du récepteur et mesurer l'équilibre à partir de la sortie du mélangeur pour établir les données d'accord d'équilibre.

9. Procédé selon l'une des revendications précédentes, comprenant en outre l'étape consistant à enregistrer dans une mémoire les données d'accord d'équilibre pour l'équilibre obtenu et charger les données d'accord d'équilibre au moyen d'un microprocesseur ou d'un processeur de signal numérique (DSP) au moment du démarrage.

10. Procédé selon l'une des revendications précédentes, conçu pour être mis en oeuvre dans un système de communication GSM.

11. Procédé selon l'une des revendications précédentes, conçu pour être mis en oeuvre dans un système de communication CDMA.

12. Procédé selon la revendication 10 ou 11, dont les étapes sont mises en oeuvre à l'aide d'un processeur de signal numérique.

13. Procédé selon la revendication 10 ou 11, dans lequel les données d'accord d'équilibre sont obtenues en couplant un signal-test à une antenne du récepteur et en exécutant un programme d'accord.

14. Procédé selon l'une des revendications précédentes, dans lequel les tensions (3) ou courants de polarisation sont réglés dans un circuit d'entrée d'un signal radiofréquence.

15. Procédé selon l'une des revendications précédentes, dans lequel les tensions (3) ou courants de polarisation sont réglés dans un circuit d'entrée d'un oscillateur local.

16. Procédé selon l'une des revendications précédentes, dans lequel les tensions (3) ou courants de polarisation sont réglés séparément pour les deux transistors d'une paire de transistors d'une ligne de signal dans le mélangeur.

17. Procédé selon l'une des revendications précédentes, dans lequel l'étape consistant à régler les tensions (3) ou courants de polarisation est mise en oeuvre à l'aide d'un convertisseur numérique-analogique pour régler le courant pour la ligne de signal aux bornes de résistances en parallèle.

18. Récepteur, comprenant :
un mélangeur (10) pour mélanger des signaux radio d'une première fréquence pour obtenir une deuxième fréquence en mélangeant les signaux radio à des signaux d'un oscillateur local, et
un moyen pour atténuer les signaux parasites lors de la réception des signaux radio,
**caractérisé en ce que** :
ledit moyen pour atténuer les signaux parasites comprend un moyen de réglage d'équilibre (12) conçu pour mesurer une erreur d'équilibre de mélangeur à la sortie du mélangeur (10), régler les tensions (3) ou courants de polarisation de transistors (Q10, Q11, Q12, Q13, Q14, Q15) du mélangeur (10) pour réduire l'erreur d'équilibre de mélangeur et obtenir ainsi des données d'accord d'équilibre pour les tensions (3) ou courants de polarisation, et lors du démarrage du mélangeur (10), générer les tensions (3) ou courants de polarisation sur la base des données d'accord d'équilibre et fixer les tensions (3) ou courants de polarisation générés des transistors (Q10, Q11, Q12, Q13, Q14, Q15) du mélangeur (10).

19. Récepteur selon la revendication 18, dans lequel un moyen de réglage d'équilibre (12) est conçue pour commander numériquement le réglage des tensions (3) ou courants de polarisation.

20. Récepteur selon la revendication 18, dans lequel un moyen de réglage d'équilibre (12) est conçue pour convertir des données de mesure de tension issues de la sortie du mélangeur indiquant l'équilibre sous forme numérique (A/D) et pour fixer les tensions (3) ou courants de polarisation réglés sur la base des données numériques.

21. Récepteur selon l'une des revendications 18 à 20, comprenant un processeur de signal numérique et/ou un microprocesseur conçu(s) pour obtenir les données d'accord d'équilibre.

22. Récepteur selon l'une des revendications 18 à 21, comprenant un programme d'accord dont l'exécution permet d'obtenir les données d'accord d'équilibre.

23. Récepteur selon l'une des revendications 18 à 22, dans lequel les données d'accord d'équilibre sont enregistrées dans une mémoire et l'opération consistant à fixer les tensions (3) ou courants de polarisation est commandée par un processeur de signal numérique.

24. Récepteur selon l'une des revendications 18 à 23, dans lequel le moyen de réglage d'équilibre est conçu pour répéter l'opération consistant à régler les tensions (3) ou courants de polarisation jusqu'à ce que l'erreur d'équilibre de mélangeur soit réduite à un minimum.

25. Récepteur selon l'une des revendications 18 à 24, comprenant en outre un trajet de signal pour recevoir un signal-test, et ledit moyen de réglage d'équilibre (12) étant conçu pour mesurer l'équilibre à partir de la sortie du mélangeur pour établir les données d'accord d'équilibre.

26. Récepteur selon l'une des revendications 18 à 25, comprenant en outre une mémoire (21) pour enregistrer les données d'accord d'équilibre pour l'équilibre obtenu et charger les données d'accord d'équilibre au moyen d'un microprocesseur ou d'un processeur de signal numérique (DSP) au moment du démarrage.

27. Récepteur selon l'une des revendications 18 à 26, conçu pour fonctionner dans un système de communication GSM.

28. Récepteur selon l'une des revendications 18 à 27, conçu pour fonctionner dans un système de communication CDMA.

29. Récepteur selon la revendication 27 ou 28, comprenant un processeur de signal numérique conçu pour mettre en oeuvre l'accord du récepteur.

30. Récepteur selon la revendication 27 ou 28, comprenant en outre un moyen pour coupler un signal-test à une antenne du récepteur et un moyen pour exécuter un programme d'accord.

31. Récepteur selon l'une des revendications 18 à 30, dans lequel le moyen de réglage (12) comprend un circuit d'entrée (VRF+, VRF-, C3, C4) pour un signal radiofréquence pour régler les tensions ou courants de polarisation d'un circuit de réglage (BRF+, BRF-, RB5, RB6, RB7, RB8).

32. Récepteur selon l'une des revendications 18 à 31, dans lequel le moyen de réglage (12) comprend un circuit d'entrée (VLO+, VLO-, C1, C2) d'un oscillateur local pour régler les tensions ou courants de polarisation d'un circuit de réglage (BLO+, BLO-, RB1, RB2, RB3, RB4).

33. Récepteur selon l'une des revendications 18 à 32, dans lequel le moyen de réglage d'équilibre (12) comprend un circuit de réglage séparément pour les deux transistors d'une paire de transistors (Q10, Q14 ; Q11, Q13) d'une ligne de signal (VLO+, VLO-) du mélangeur (10) pour ajuster les tensions ou courants de polarisation.

34. Récepteur selon l'une des revendications 18 à 33, dans lequel le moyen de réglage d'équilibre comprend un convertisseur numérique-analogique (19) pour régler les tensions ou courants de polarisation à l'aide d'une unité de commande numérique (12).

35. Récepteur selon l'une des revendications 18 à 34, comprenant en outre :
un convertisseur analogique-numérique (18) pour mesurer l'équilibre ;
un convertisseur numérique-analogique (19) pour régler les tensions ou courants de polarisation ; et
un oscillateur (15), un processeur (16) et une mémoire (17) pour mettre en oeuvre des procédures de mesure d'équilibre ainsi que des procédures de réglage de tensions ou courants de polarisation.

36. Station mobile, comprenant un récepteur selon l'une quelconque des revendications 18 à 35.

37. Utilisation d'un mélangeur dans un récepteur selon l'une quelconque des revendications 18 à 35.
